# EUROPÄISCHE PATENTSCHRIFT

(11) **EP 2 580 792 B1**
(45) Veröffentlichungstag und Bekanntmachung des Hinweises auf die Patenterteilung: **16.05.2018**
(21) Anmeldenummer: 11723981.4
(22) Anmeldetag: 08.06.2011
(51) Int. Cl.: H01L 23/00, H01L 33/62, H01L 33/38, H01L 33/00

(54) **STRAHLUNGSEMITTIERENDER HALBLEITERKÖRPER, VERFAHREN ZUR HERSTELLUNG EINES STRAHLUNGSEMITTIERENDEN HALBLEITERKÖRPERS UND STRAHLUNGSEMITTIERENDES HALBLEITERBAUELEMENT**
RADIATION-EMITTING SEMICONDUCTOR BODY, METHOD FOR PRODUCING A RADIATION-EMITTING SEMICONDUCTOR BODY, AND RADIATION-EMITTING SEMICONDUCTOR COMPONENT
CORPS SEMI-CONDUCTEUR ÉMETTEUR DE RAYONNEMENT, PROCÉDÉ DE FABRICATION D'UN CORPS SEMI-CONDUCTEUR ÉMETTEUR DE RAYONNEMENT ET COMPOSANT SEMI-CONDUCTEUR ÉMETTEUR DE RAYONNEMENT

(30) Priorität: 10.06.2010 DE 102010023343
(43) Veröffentlichungstag der Anmeldung: 17.04.2013
(60) Teilanmeldung: 18158977.1
(73) Patentinhaber: OSRAM Opto Semiconductors GmbH, 93055 Regensburg (DE)
(72) Erfinder: BRUNNER, Herbert, 93161 Sinzing (DE); NINZ, Patrick, 93049 Regensburg (DE)
(74) Vertreter: Epping - Hermann - Fischer
(86) Internationale Anmeldenummer: PCT/EP2011/059485
(87) Internationale Veröffentlichungsnummer: WO 2011/154441

(56) Entgegenhaltungen:
- EP-A2- 2 357 681
- US-A- 5 779 924
- US-A- 6 025 650
- US-A1- 2002 052 062
- US-A1- 2003 197 191
- US-A1- 2005 017 252
- US-A1- 2006 043 399
- US-A1- 2008 142 817
- US-B1- 7 687 322

## Beschreibung

Die Erfindung betrifft einen strahlungsemittierenden Halbleiterkörper, ein Verfahren zur Herstellung eines strahlungsemittierenden Halbleiterkörpers und ein strahlungsemittierendes Halbleiterbauelement.
Die Druckschrift EP 1 657 757 A2 beschreibt ein strahlungsemittierendes Halbleiterbauelement mit einem strahlungsemittierenden Halbleiterkörper, der mit einem Fügeverfahren, wie beispielsweise Ultraschallreibschweißen oder Thermokompression über rückseitige elektrische Kontakte elektrische leitend auf einen Chipträger aufgebracht ist. Zur Herstellung der rückseitigen Kontakte werden auf den Halbleiterkörper einzelne leitfähige Kontakte nach einander mit Hilfe eines Ballbonders aufgebracht, wie beispielsweise in der Druckschrift US 2005/0247944 A1 beschrieben. Dieses Herstellungsverfahrens ist aufgrund der seriellen Prozessführung vergleichsweise zeitaufwendig.
Weiterhin beschreiben die Druckschriften US 2003/0197191 A1, US 7,687,322 B2, US 5,779,924 A, EP 2357681 A2 und KR 20100014161 strahlungsemittierende Halbleiterkörper und/oder Verfahren zu deren Herstellung.
Aufgabe der vorliegenden Erfindung ist es, einen Halbleiterkörper anzugeben, der dazu geeignet ist, mit einem Fügeverfahren, insbesondere Ultraschallreibschweißen oder Thermokompression auf einen Chipträger aufgebracht zu werden. Weiterhin ist es Aufgabe der vorliegenden Erfindung, ein vereinfachtes Verfahren zur Herstellung eines solchen Halbleiterkörpers anzugeben. Eine weitere Aufgabe der vorliegenden Erfindung besteht darin, ein strahlungsemittierendes Bauelement mit einem solchen strahlungsemittierenden Halbleiterkörper anzugeben.

Diese Aufgaben werden durch einen Halbleiterkörper mit den Merkmalen des Patentanspruchs 1, durch ein Verfahren mit den Schritten des Patentanspruchs 7 und durch ein strahlungsemittierendes Halbleiterbauelement mit den Merkmalen des Patentanspruchs 12 gelöst.

Vorteilhafte Weiterbildungen und Ausführungsformen sind jeweils in den abhängigen Ansprüchen angegeben.

Ein strahlungsemittierender Halbleiterkörper umfasst insbesondere:
- eine epitaktische Halbleiterschichtenfolge mit einer aktiven Zone, die dazu geeignet ist, elektromagnetische Strahlung zu erzeugen,
- eine Trägerschicht, die dazu vorgesehen ist, die epitaktische Halbleiterschichtenfolge mechanisch zu stabilisieren, und
- Kontaktstrukturen zur elektrischen Kontaktierung des Halbleiterkörpers, die jeweils einen Volumenbereich und einen Oberflächenfügebereich aufweist. Der Oberflächenfügebereich ist weiterhin aus einem Material gebildet, das von dem Material des Volumenbereichs verschieden ist.

Der Oberflächenfügebereich ist insbesondere dazu geeignet, mit Hilfe eines Fügeverfahrens, wie Ultraschallreibschweißen und/oder Thermokompression mit einem Chipträger verbunden zu werden. Besonders bevorzugt ist die Verbindung zwischen dem Chipträger und dem Oberflächenfügebereich elektrisch leitend ausgebildet. Besonders bevorzugt ist der Oberflächenfügebereich ultraschallreibschweißfähig und/oder thermokompressionsfähig ausgebildet, dass heißt er kann mittels Ultraschallreibschweißen und/oder Thermokompression mit dem Chipträger verbunden werden.

Die Kontaktstrukturen sind an der Rückseite des Halbleiterkörpers angeordnet, wobei die Rückseite einer strahlungsemittierenden Vorderseite des Halbleiterkörpers gegenüberliegt.
Gemäß einer Ausführungsform ist jeweils eine einzige Kontaktstruktur durch jeweils einen einzigen Volumenbereich und einen einzigen Oberflächenfügebereich gebildet.

Die Trägerschicht ist metallisch ausgebildet und weist beispielsweise zumindest eines der folgenden Materialien auf oder besteht aus zumindest einem dieser Materialien: Nickel, Molybdän, Kupfer. Diese Materialien können beispielsweise mittels eines galvanischen Prozesses auf die epitaktische Halbleiterschichtenfolge aufgebracht sein.
Gemäß einer Ausführungsform des strahlungsemittierenden Halbleiterkörpers ist der Volumenbereich aus dem gleichen Material wie die Trägerschicht gebildet. Hiermit ist nicht zwingend gemeint, dass die Volumenbereiche der Kontaktstrukturen aus dem Material der Trägerschicht gebildet sind, beispielsweise durch ein subtraktives Verfahren, wie es weiter unten im Detail beschreiben ist. Vielmehr ist es auch möglich, dass zur Bildung der Volumenbereiche der Kontaktstrukturen eine weitere Schicht, die das gleiche Material der Trägerschicht aufweist oder aus dem gleichen Material besteht, strukturiert auf die Trägerschicht aufgebracht wird.

Hierbei ist es auch möglich, dass sich das Material des Volumenbereiches und das Material der Trägerschicht geringfügig voneinander unterscheiden, beispielsweise aufgrund unterschiedlicher oder nacheinander stattfindender Herstellungsprozesse.

Besonders bevorzugt weist die weitere Schicht ein metallisches Material, wie beispielsweise Nickel, Molybdän oder Kupfer auf oder besteht aus einem dieser Materialien.

Gemäß einer weiteren Ausführungsform des strahlungsemittierenden Halbleiterkörpers sind die Kontaktstrukturen durch Vorsprünge ausgebildet, die jeweils vorzugsweise eine Breite zwischen 20 µm und 200 µm aufweisen, wobei die Grenzen eingeschlossen sind.

Gemäß einer weiteren Ausführungsform des strahlungsemittierenden Halbleiterkörpers sind die Kontaktstrukturen durch Vorsprünge gebildet, die jeweils vorzugsweise eine Höhe zwischen 5 µm und 50 µm aufweisen, wobei die Grenzen eingeschlossen sind.

Gemäß einer weiteren Ausführungsform des strahlungsemittierenden Halbleiterkörpers weist der Oberflächenfügebereich zumindest eines der folgenden Materialien auf oder besteht aus zumindest einem der folgenden Materialien: Gold, Kupfer, Aluminium. Besonders bevorzugt wird hierbei Gold verwendet, da seine Materialeigenschaften, wie beispielsweise die Duktilität, besonders gut für die Fügeverfahren Ultraschallreibschweißen und Thermokompression geeignet sind. Weiterhin weist Gold im Unterschied zu anderen Metallen, wie beispielsweise Kupfer oder Aluminium vorteilhafterweise höchstens eine sehr geringfügige Oxidschicht auf seiner Oberfläche auf, so dass ein Schritt zur Entfernung der Oxidschicht vor dem Ultraschallreibschweißen oder der Thermokompression, wie er in der Regel etwa bei Verwendung von Kupfer oder Aluminium durchgeführt wird, entfallen kann.
Wird Kupfer oder Aluminium für den Oberflächenfügebereich eingesetzt, so wird ein nachfolgender Verbindungsschritt zur Verbindung des Halbleiterkörpers mit einem Chipträger, beispielsweise mittels Ultraschallreibschweißen oder Thermokompression, besonders bevorzugt unter einer Schutzatmosphäre aus einem inerten Gas, wie beispielsweise Stickstoff oder einem Edelgas durchgeführt.

Gemäß der Ausführungsform des strahlungsemittierenden Halbleiterkörpers sind die Kontaktstrukturen durch Vorsprünge gebildet, wobei die Oberflächenbereiche die Volumenbereiche jeweils beidseitig überragen. Die Kontaktstrukturen sind hierbei durch pilzförmige Vorsprünge gebildet, wobei die Volumenbereiche den Stil der Pilze und die Oberflächenfügebereiche die Kappe der Pilze ausbilden. Pilzförmige Vorsprünge können insbesondere durch galvanisches Abscheiden der Oberflächenfügebereiche über einer Fotolackmaske erzeugt werden, wie weiter unten im Detail beschrieben. Da galvanische Abscheideprozesse in der Regel isotropen Charakter haben, bilden sich hierbei kappenförmige Strukturen mit abgerundeten Kanten aus.

Gemäß einer weiteren Ausführungsform des strahlungsemittierenden Halbleiterkörpers weisen die Kontaktstrukturen jeweils eine rechteckige, quadratische, runde oder kreisförmige Grundfläche auf.

Ein Verfahren zur Herstellung eines Halbleiterkörpers umfasst insbesondere die folgenden Schritte:
- Bereitstellen einer epitaktischen Halbleiterschichtenfolge mit einer aktiven Zone, die dazu geeignet ist, elektromagnetische Strahlung zu erzeugen,
- Aufbringen einer Trägerschicht auf eine Hauptseite der epitaktischen Halbleiterschichtenfolge, wobei die Trägerschicht zur mechanischen Stabilisierung der epitaktische Halbleiterschichtenfolge vorgesehen ist,
- Aufbringen einer fügefähigen Schicht,
- Ausbilden von Kontaktstrukturen mittels Fotolithographie auf der Trägerschicht, wobei die Kontaktstrukturen jeweils einen Volumenbereich und einen Oberflächenfügebereich aufweisen.

Die epitaktische Halbleiterschichtenfolge wird in der Regel auf einem geeigneten Aufwachssubstrat epitaktisch aufgewachsen.

Das Aufwachssubstrat wird nach dem Aufbringen der Trägerschicht in der Regel von der epitaktischen Halbleiterschichtenfolge entfernt oder derart gedünnt, dass es alleine nicht dazu geeignet ist, die epitaktische Halbleiterschichtenfolge mechanisch zu stabilisieren.

Das Aufwachssubstrat wird beispielsweise durch Polieren, Ätzen oder mit Hilfe eines Laser-Lift-Off-Verfahrens von der epitaktischen Halbleiterschichtenfolge entfernt bzw. entsprechend gedünnt.

Die Trägerschicht, insbesondere eine metallische Trägerschicht, wird beispielsweise mittels eines galvanischen Abscheideprozesses, Sputtern oder Aufdampfen auf die epitaktische Halbleiterschichtenfolge aufgebracht.

Die fügefähige Schicht, insbesondere wenn diese ein metallisches Material aufweist, wird ebenfalls beispielsweise durch einen galvanischen Prozess, durch Sputtern oder Aufdampfen erzeugt. Bevorzugt werden die Oberflächenfügebereiche aus dem Material der fügefähigen Schicht gebildet.

Die fügefähige Schicht ist besonders bevorzugt ultraschallreibschweißfähig und/oder thermokompressionsfähig ausgebildet. Insbesondere weist die fügefähige Schicht zumindest eines der folgenden Materialien auf oder besteht aus zumindest einem der folgenden Materialien: Gold, Kupfer, Aluminium.

Gemäß einer Ausführungsform des Verfahrens wird zwischen die Trägerschicht und die fügefähige Schicht eine weitere Schicht auf die Trägerschicht aufgebracht. Die weitere Schicht weist bevorzugt das gleiche Material wie die Trägerschicht auf. Besonders bevorzugt ist die weitere Schicht aus dem gleichen Material wie die Trägerschicht gebildet, das heißt, dass die Materialzusammensetzung der weiteren Schicht innerhalb von Herstellungstoleranzen nicht wesentlich von der Materialzusammensetzung der Trägerschicht abweicht. Aufgrund unterschiedlicher Herstellungstechnologien oder zweier aufeinander folgender Prozessschritte zur Herstellung der Trägerschicht und der weiteren Schicht können jedoch geringfügige Abweichungen in der Materialzusammensetzung der beiden Schichten auftreten.

Gemäß einer weiteren Ausführungsform des Verfahrens werden die Volumenbereiche der Kontaktstrukturen aus dem Material der weiteren Schicht gebildet. Bei dieser Ausführungsform des Verfahrens handelt es sich um ein additives Verfahren, da das Material, aus dem die Volumenbereiche der Kontaktstrukturen gebildet wird, in Form einer zusätzlichen Schicht zur Verfügung gestellt wird.

Zur Bildung der Kontaktstrukturen wird beispielsweise auf die Trägerschicht eine Fotolackschicht aufgebracht, die die Bereiche freilässt, in denen die Vorsprünge der Kontaktstrukturen gebildet werden sollen. Nachfolgend wird - beispielsweise galvanisch - die weitere Schicht abgeschieden, so dass diese die freien Bereiche innerhalb der Fotolackschicht ausfüllt. Hierbei ist es möglich, dass die weitere Schicht die gesamten Ausnehmungen innerhalb der Fotolackschicht vollständig oder nur teilweise ausfüllt. Zur Bildung der Oberflächenfügebereiche wird dann bei dieser Ausführungsform des Verfahrens bevorzugt eine weitere fügefähige Schicht abgeschieden, die ebenfalls der durch die Fotolackschicht vorgegebenen Strukturierung folgt. Zuletzt wird die Fotolackschicht entfernt, so dass lediglich die Kontaktstrukturen in Form von Vorsprüngen mit jeweils einem Volumenbereich und jeweils einem Oberflächenfügebereich auf der Trägerschicht verbleiben.

Alternativ zu dem oben beschriebenen additiven Verfahren, kann auch ein subtraktives Verfahren durchgeführt werden. Bei dem subtraktiven Verfahren werden die Volumenbereiche der Kontaktstrukturen direkt aus dem Material der Trägerschicht gebildet, beispielsweise durch Ätzen.

Ein besonderer Vorteil des hier beschriebenen Verfahrens besteht darin, dass es auf Waferlevel, das heißt, vor Vereinzelung der Halbleiterkörper, durchgeführt werden kann. Dies erlaubt eine einfache und schnelle Herstellung der Kontaktstrukturen. Weiterhin können aufgrund der Fotostrukturierung die Kontaktstrukturen in einem parallelen Prozess erzeugt werden.

Die erzielten Kontaktstrukturen sind weiterhin thermisch und elektrisch gut leitfähig und können in wenigen Prozessschritten erzielt werden. Weiterhin findet bei dem Verfahren zur Herstellung der Kontaktstrukturen lediglich ein geringer Temperatureintrag in den Halbleiterkörper und insbesondere in die Halbleiterschichtenfolge mit der aktiven strahlungserzeugenden Zone statt. Außerdem macht das hier vorgeschlagene Herstellungsverfahren eine Reinigung des Halbleiterkörpers im Anschluss in der Regel überflüssig.

Gemäß einer weiteren Ausführungsform wird die fügefähige Schicht in direktem Kontakt auf die Trägerschicht aufgebracht.

Ein strahlungsemittierendes Halbleiterbauelement kann beispielsweise durch Aufbringen eines der oben beschriebenen strahlungsemittierenden Halbleiterkörper auf einen Chipträger hergestellt werden. Besonders bevorzugt wird der Halbleiterkörper mittels Ultraschallreibschweißen oder Thermokompression auf dem Chipträger aufgebracht. Hierzu weist der Träger bevorzugt Kontaktbereiche auf, die dazu vorgesehen sind, mit den Kontaktstrukturen des Halbleiterkörpers verbunden zu werden. Die Kontaktbereiche weisen bevorzugt eine Metallisierung auf, die ultraschallreibschweißfähig und/oder thermokompressionsfähig ist. Hierzu ist beispielsweise eine Metallisierung geeignet, die aus einer der folgenden Materialien besteht oder eines der folgenden Materialien aufweist: Gold, Kupfer, Aluminium.

Vorteilhafterweise können mehrere Halbleiterkörper mit den Fügeverfahren Ultraschallreibschweißen bzw. Thermokompression in geringeren Abständen zueinander beispielsweise auf einem Träger befestigt werden, als etwa mit Kleben oder Löten.

Gemäß einer weiteren Ausführungsform des strahlungsemittierenden Halbleiterbauelements ist zumindest zwischen den Kontaktstrukturen ein elektrisch isolierendes Füllmaterial eingebracht. Das Füllmaterial wird bevorzugt nach dem Aufbringen auf einen Träger zwischen die Kontaktstrukturen eingebracht.

Weitere vorteilhafte Ausführungsformen und Weiterbildungen der Erfindung ergeben sich aus den im Folgenden in Verbindung mit den Figuren beschriebenen Ausführungsbeispielen.
Figuren 1A bis 1G zeigen schematische Schnittdarstellungen eines Waferverbundes während verschiedener Verfahrensschritte gemäß einem ersten Ausführungsbeispiel.
Figur 2 zeigt eine schematische Schnittdarstellung eines Halbleiterkörpers gemäß einem Ausführungsbeispiel.
Figuren 3A und 3B zeigen jeweils eine schematische Draufsicht auf einen Halbleiterkörper gemäß zweier verschiedener Ausführungsbeispiele.
Figuren 4A bis 4F zeigen schematische Schnittdarstellungen eines Waferverbundes während verschiedener Verfahrensschritte gemäß einem weiteren Ausführungsbeispiel, der jedoch nicht zu der beanspruchten Erfindung gehört.
Figuren 5A bis 5E zeigen schematische Schnittdarstellungen eines Waferverbundes während verschiedener Verfahrensschritte gemäß einem weiteren Ausführungsbeispiel, der jedoch nicht zu der beanspruchten Erfindung gehört.
Figuren 6A bis 6H zeigen schematische Schnittdarstellungen eines Waferverbundes während verschiedener Verfahrensschritte gemäß einem weiteren Ausführungsbeispiel.
Figuren 7A bis 7D zeigen schematische Schnittdarstellungen eines strahlungsemittierenden Halbleiterbauelements während verschiedener Verfahrensschritte gemäß einem Ausführungsbeispiel.

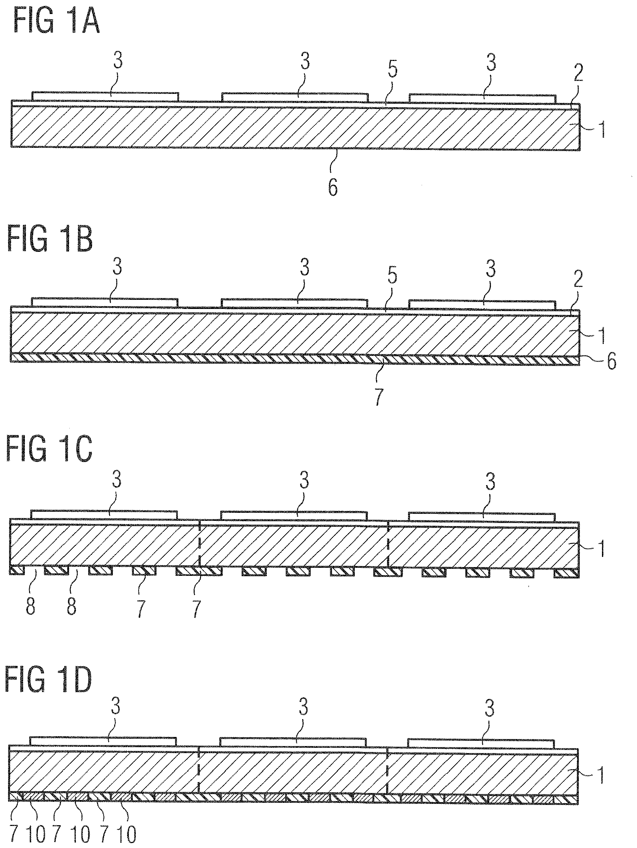

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente, insbesondere Schichtdicken zur besseren Darstellbarkeit und/oder zum besseren Verständnis übertrieben groß dargestellt sein. Figur 1A zeigt eine Trägerschicht 1, auf deren erste Hauptseite 2 eine epitaktische Halbleiterschichtenfolge 3 angeordnet ist. Die Trägerschicht 1 stabilisiert die Halbleiterschichtenfolge 3 mechanisch. Die epitaktische Halbleiterschichtenfolge 3 ist vorliegend bereits in Chipbereiche strukturiert, von denen jeweils ein Chipbereich später Teil eines fertigen Halbleiterkörper ist. Die epitaktische Halbleiterschichtenfolge 3 weist eine aktive Zone 4 auf (in den Figuren 1A bis 1G nicht dargestellt), die dazu geeignet ist, elektromagnetische Strahlung zu erzeugen.

Besonders bevorzugt ist die weitere Schicht 10 metallisch ausgebildet und weist das gleiche Material auf, wie die Trägerschicht 1, beispielsweise Nickel, Molybdän, Kupfer.

Die Trägerschicht 1 ist vorliegend metallisch ausgebildet und weist beispielsweise Nickel, Molybdän, Kupfer auf.

Die aktive Zone 4 umfasst bevorzugt einen pn-Übergang, eine Doppelheterostruktur, einen Einfach-Quantentopf oder besonders bevorzugt eine Mehrfach-Quantentopfstruktur (MQW) zur Strahlungserzeugung. Die Bezeichnung Quantentopfstruktur beinhaltet hierbei keine Angabe über die Dimensionalität der Quantisierung. Sie umfasst somit u.a. Quantentröge, Quantendrähte und Quantenpunkte und jede Kombination dieser Strukturen.

Zwischen der Trägerschicht 1 und den strukturierten epitaktischen Halbleiterschichtenfolgen 3 ist eine Schicht 5 angeordnet. Bei dieser Schicht 5 kann es sich beispielsweise um eine Fügeschicht zur Verbindung der epitaktischen Halbleiterschichtenfolge 3 mit der Trägerschicht 1 handeln, die etwa ein Lot oder einen Klebstoff aufweist. Weiterhin kann es sich bei der Schicht 5 auch um eine metallische Starterschicht handeln, falls die Trägerschicht 1 galvanisch aufgewachsen wird.

Wie in Figur 1B beispielhaft dargestellt, wird auf die zweite Hauptseite 6 der Trägerschicht 1, die der ersten Hauptseite 2 gegenüber liegt, eine Fotolackschicht 7 aufgebracht.

Die Fotolackschicht 7 wird nun derart strukturiert, dass Öffnungen 8 in der Fotolackschicht 7 entstehen, die die Fotolackschicht7 komplett durchdringen (Figur 1C). Die Öffnungen 8 in der Fotolackschicht 7 geben die Form der später erzeugten Kontaktstrukturen 9 vor.

In einem nächsten Verfahrensschritt, der in Figur 1D dargestellt ist, wird eine weitere Schicht 10 über der Fotolackschicht 7 abgeschieden, wobei das Material der weiteren Schicht 10 die Öffnungen 8 in der Fotolackschicht 7 vollständig bis zum Rand der Fotolackschicht 7 ausfüllt. Die weitere Schicht 10 wird somit gemäß der Fotolackschicht 7 strukturiert auf die Trägerschicht 1 aufgebracht. Aus dem Material der metallischen Schicht 10 werden die Volumenbereiche 11 der Kontaktstrukturen 9 gebildet. Es handelt sich daher bei dem Verfahren gemäß dem Ausführungsbeispiel der Figuren 1A bis 1G um ein additives Verfahren.

Besonders bevorzugt ist die weitere Schicht 10 metallisch ausgebildet und weist das gleiche Material auf, wie die Trägerschicht 1, beispielsweise Nickel, Molybdän, Kupfer.

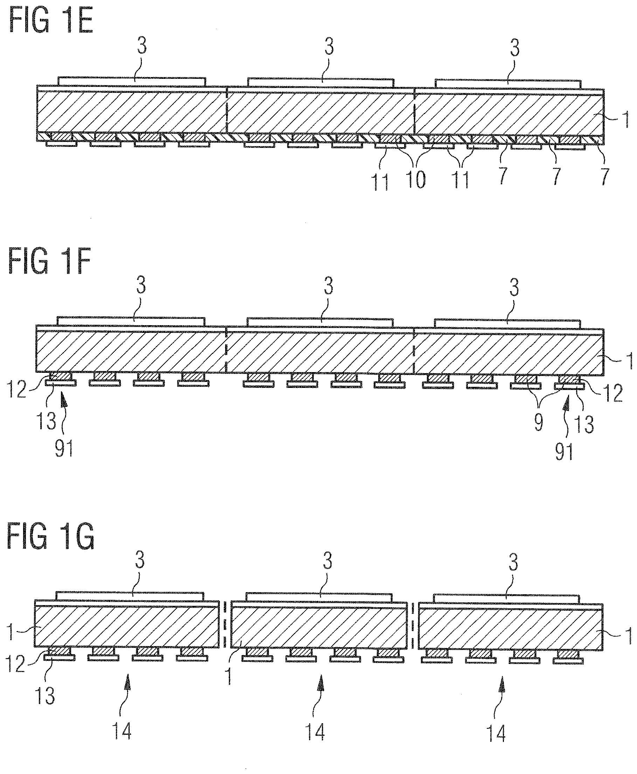

In einem weiteren Verfahrensschritt wird nun eine fügefähige Schicht 11 auf die weitere Schicht 10 aufgebracht (Figur 1E). Die fügefähige Schicht 11 ist bevorzugt ultraschallreibschweißfähig und/oder thermokompressionsfähig ausgebildet und weist eines der folgenden Materialien auf: Gold, Kupfer, Aluminium. Das Aufbringen der fügefähigen Schicht 11 erfolgt beispielsweise mit einem galvanischen Abscheideprozess. Hierbei bildet die Oberfläche der weiteren Schicht 10 einen Ansatzpunkt zur Abscheidung der fügefähigen Schicht 11, sodass hierbei ausgehend von der darunterliegenden strukturierten weiteren Schicht 10 kappenförmige Strukturen entstehen.

In einem weiteren Schritt, der schematisch in Figur 1F dargestellt ist, wird die Fotolackschicht 7 entfernt. Auf diese Art und Weise entstehen auf der zweiten Hauptseite 6 der Trägerschicht 1 Kontaktstrukturen 9, die jeweils einen Volumenbereich 12 und einen Oberflächenfügebereich 13 aufweisen. Der Oberflächenbereich 13 wird hierbei aus dem Material der fügefähigen Schicht 11 gebildet. Ist die fügefähige Schicht 11 somit ultraschallreibschweißfähig und/oder thermokompressionsfähig, so ist auch der Oberflächenbereich 13 ultraschallreibschweißfähig und/oder thermokompressionsfähig.

In einem nächsten Schritt wird der Waferverbund zu einzelnen Halbleiterkörpern 14 vereinzelt (Figur 1G).

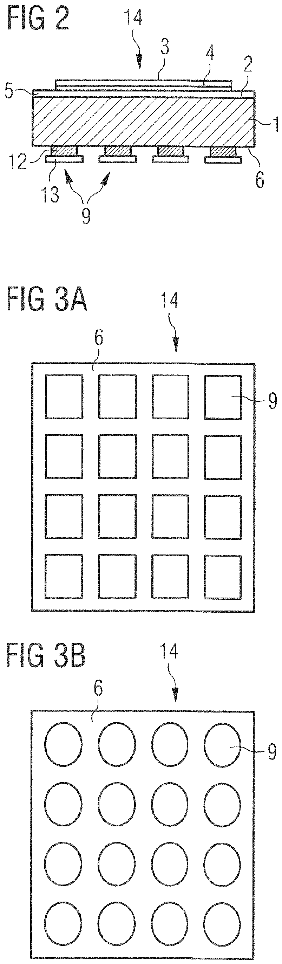

Mit dem Verfahren gemäß der Figuren 1A bis 1G kann beispielsweise ein strahlungsemittierender Halbleiterkörper 14 hergestellt werden, wie er schematisch in Figur 2 dargestellt ist.

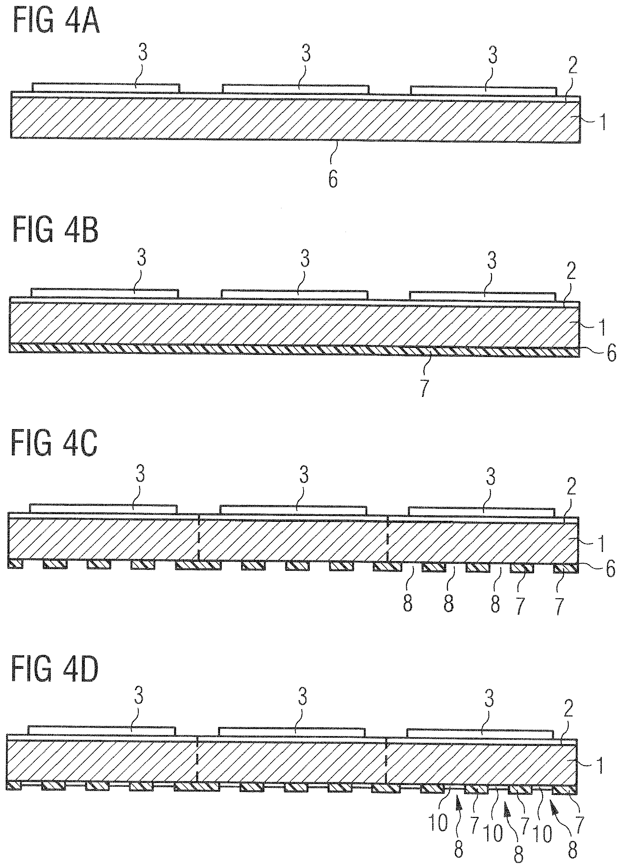

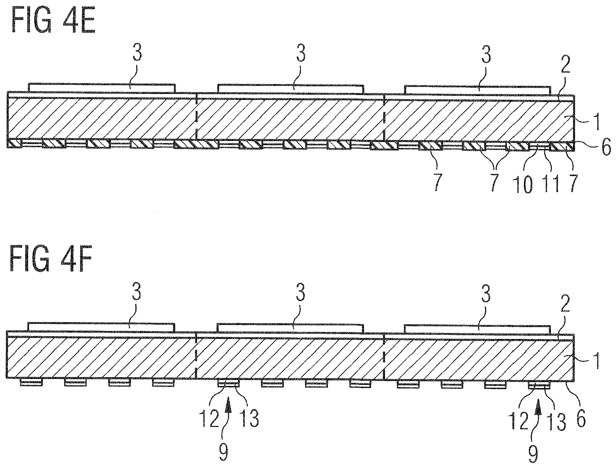

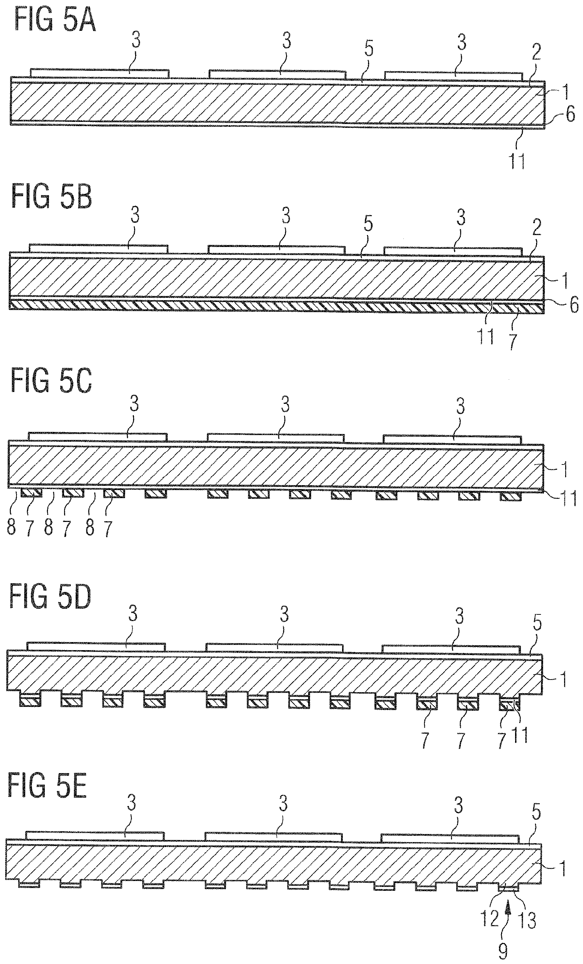

Der Halbleiterkörper 14 gemäß dem Ausführungsbeispiel der Figur 2 weist eine epitaktisch gewachsene Halbleiterschichtenfolge 3 auf, die eine aktive Zone 4 umfasst. Die epitaktische Halbleiterschichtenfolge 3 ist auf der ersten Hauptseite 2 einer Trägerschicht 1 angeordnet, wobei die Trägerschicht 1 dazu dient, die epitaktische Halbleiterschichtenfolge 3 mechanisch zu stabilisieren. Zwischen der epitaktischen Halbleiterschichtenfolge 3 und der Trägerschicht 1 ist eine Schicht 5 angeordnet.
Auf der zweiten Hauptseite 6 der Trägerschicht 1 sind Kontaktstrukturen 9 angeordnet. Die Kontaktstrukturen 9 umfassen Volumenbereiche 12, die aus dem gleichen Material gebildet sind, wie die Trägerschicht 1. Weiterhin umfassen die Kontaktstrukturen 9 Oberflächenfügebereiche 13, die bevorzugt ultraschallreibschweißfähig und/oder thermokompressionsfähig ausgebildet sind. Der Oberflächenfügebereich 13 einer Kontaktstruktur 91 ist vorliegend in direktem Kontakt mit dem Volumenbereich 12 angeordnet. Weiterhin sind die Volumenbereiche 12 der Kontaktstrukturen 9 in direktem Kontakt mit der Trägerschicht 1 angeordnet.
Bei dem Halbleiterkörper 14 gemäß Figur 2 sind die Kontaktstrukturen 9 durch pilzförmige Vorsprünge gebildet, wobei der Volumenbereich 12 den Stil des Pilzes und der Oberflächenfügebereich 13 die Kappe des Pilzes ausbildet. Der Oberflächenfügebereich 13 ragt somit lateral über den Volumenbereich 12 hinaus und weist abgerundete Kanten auf. Wie in der Draufsicht auf einen Halbleiterkörper in Figur 3A exemplarisch dargestellt, können die Grundflächen der Kontaktstrukturen 9 jeweils rechteckig oder quadratisch ausgebildet sein. Weiterhin können die Grundflächen der Kontaktstrukturen 9 auch rund oder kreisförmig ausgebildet sein (Figur 3B).
Anhand der Figuren 4A bis 4F wird im Folgenden ein weiteres Ausführungsbeispiel, das jedoch nicht zu der beanspruchten Erfindung gehört, eines additiven Verfahrens zur Herstellung der Kontaktstrukturen 9 beschrieben. Die Verfahrensschritte gemäß der Figuren 4A bis 4C entsprechen hierbei im Wesentlichen den Verfahrensschritten gemäß der Figuren 1A bis 1C.
Im Unterschied zu dem Verfahren gemäß dem Ausführungsbeispiel der Figuren 1A bis 1G wird jedoch die weitere Schicht 10 derart auf der strukturierten Fotolackschicht 7 abgeschieden, dass ihr Material die Öffnungen 8 in der Fotolackschicht 7 nur teilweise füllt (Figur 4D). In einem nachfolgenden Schritt wird nun die fügefähige Schicht 11 aufgebracht, wobei auch diese die verbleibende Höhe der Öffnungen 8 nicht vollständig ausfüllt (Figur 4E).
In einem weiteren Schritt wird nun die Fotolackschicht 7 entfernt (Figur 4F) und die Halbleiterkörper 14 vereinzelt (nicht dargestellt).
Auf diese Art und Weise entstehen Kontaktstrukturen 9, bei denen im Gegensatz zu den Kontaktstrukturen 9 gemäß der Figur 2 die Oberflächenfügebereiche 13 seitlich mit den Volumenbereichen 12 abschließt.
Im Folgenden wird anhand der Figuren 5A bis 5E ein Ausführungsbeispiel, das jedoch nicht zu der beanspruchten Erfindung gehört, eines subtraktiven Verfahrens näher erläutert.
Figur 5A zeigt eine bereits in einzelne Chipbereiche strukturierte epitaktische Halbleiterschichtenfolge 3, die auf einer Trägerschicht 1 angeordnet ist. Zwischen der Trägerschicht 1 und der epitaktischen Halbleiterschichtenfolge 3 ist eine Schicht 5 angeordnet, bei der es sich beispielsweise um eine reflektierende Schicht handeln kann.

Im Unterschied zu den Figuren 1A und 4A ist bei dem Waferverbund gemäß Figur 5A auf der zweiten Hauptseite 6 der Trägerschicht 1, eine fügefähige Schicht 11, beispielsweise aus Gold, unstrukturiert aufgebracht. Auf die fügefähige Schicht 11 wird, wie in Figur 5B zu sehen, eine Fotolackschicht 7 aufgebracht, die anschließend entsprechend der gewünschten Kontaktstrukturen 9 strukturiert wird (Figur 5C). Die Fotolackschicht 7 weist hierbei entsprechend der später zu erzeugenden Kontaktstrukturen 9 Öffnungen 8 auf, die die Fotolackschicht 7 vollständig durchdringen.

In einem nächsten Schritt werden die fügefähige Schicht 11 und ein Teil der Trägerschicht 1 entsprechend der strukturierten Fotolackschicht 7 strukturiert, beispielsweise mittels nasschemischen Ätzens (Figur 5D). Danach wird die Fotolackschicht 7 wieder entfernt (Figur 5E).

Auch bei diesem Verfahren entstehen Kontaktstrukturen 9, von denen jede einen Volumenbereich 12 und einen Oberflächenfügebereich 13 aufweist. Der Oberflächenfügebereich 13 schließt hierbei seitlich mit dem Volumenbereich 12 ab.

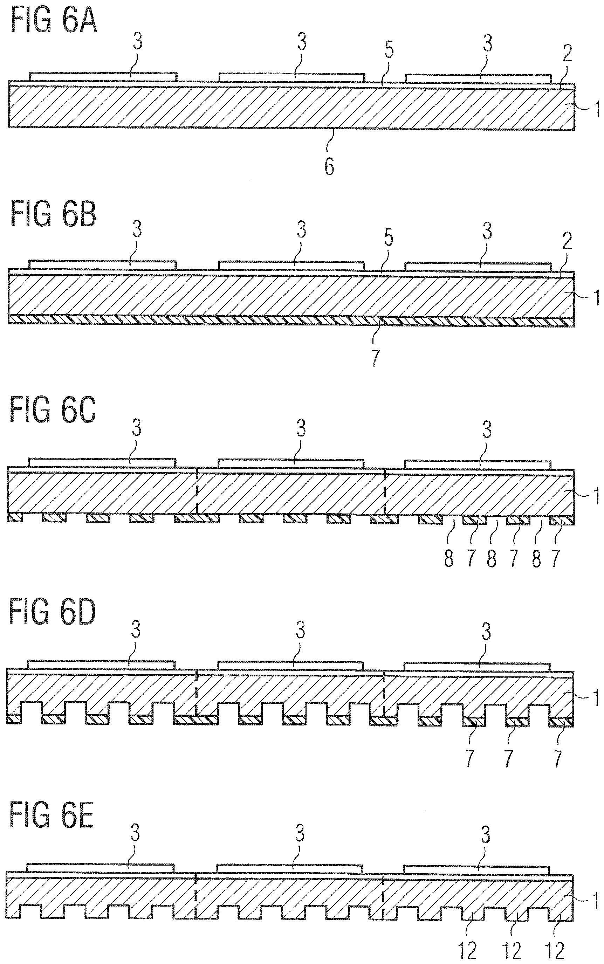

Anhand der Figuren 6A bis 6H wird im Folgenden ein weiteres Ausführungsbeispiel eines subtraktiven Verfahrens beschrieben. Die Verfahrensschritte gemäß der Figuren 6A bis 6C entsprechen hierbei im Wesentlichen den Verfahrensschritten gemäß der Figuren 1A bis 1C.

Im Unterschied zu dem Verfahren gemäß der Figuren 1A bis 1G wird jedoch nach der Strukturierung der Fotolackschicht 7 keine weitere Schicht 10 aufgebracht, sondern das Material der Trägerschicht 1 selbst innerhalb der Öffnungen 8 der Fotolackschicht 7 entfernt, beispielsweise mittels Ätzen (Figur 6D). Nach Entfernen der Fotolackschicht 7 entstehen auf diese Art und Weise, wie in Figur 6E gezeigt, Volumenbereiche 12 der späteren Kontaktstrukturen 9.

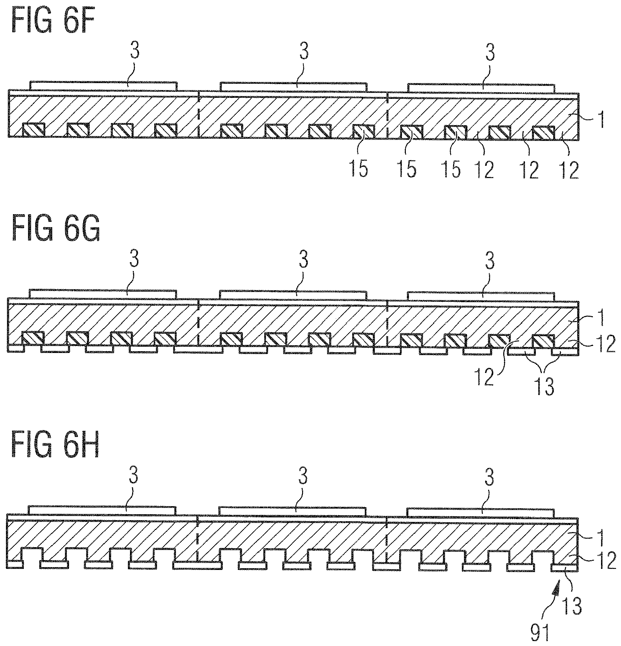

In einem nächsten Schritt wird eine weitere Fotolackschicht 15 strukturiert auf die zweite Hauptseite 6 der Trägerschicht 1 derart aufgebracht, dass das Material der weiteren Fotolackschicht 15 die Vertiefungen zwischen den Volumenbereichen 12 der Kontaktstrukturen 9 vollständig ausfüllt (Figur 6F).

In einem nächsten Schritt wird nun eine fügefähige Schicht 11 auf der weiteren Fotolackschicht 15 aufgebracht, beispielsweise durch galvanische Abscheidung (Figur 6G).

Nach Entfernen der zweiten Fotolackschicht 15 entstehen somit Kontaktstrukturen 9, wobei jede Kontaktstruktur 91 aus einem Volumenbereich 12 und einem Oberflächenfügebereich 13 gebildet ist. Der Volumenbereich 12 ist hierbei aus dem Material der Trägerschicht 1 gebildet und der Oberflächenfügebereich 13 weist bevorzugt ein thermokompressionsfähiges und/oder ultraschallreibschweißfähiges Material auf, das vorzugsweise von dem Material des Volumenbereichs 12 verschieden ist (Figur 6H).

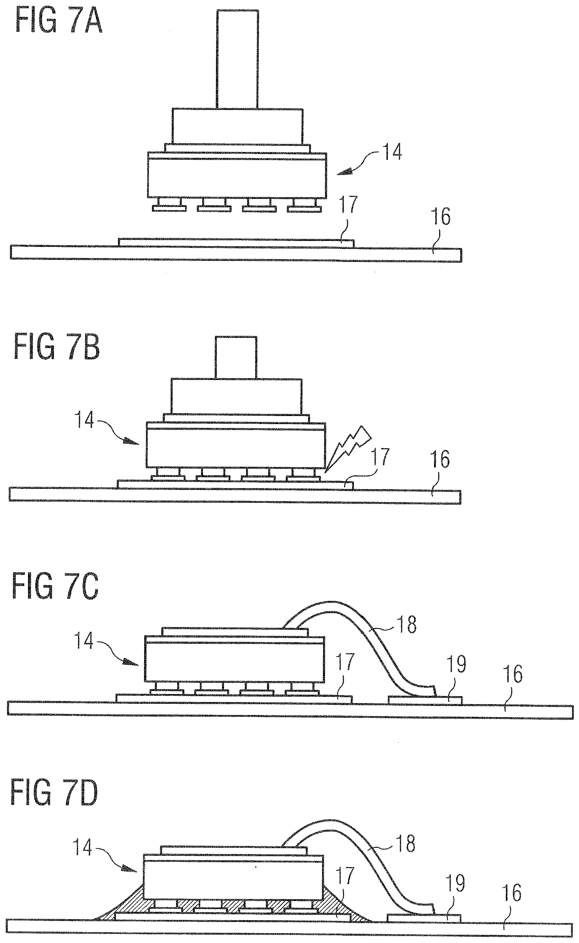

Bei dem Verfahren gemäß dem Ausführungsbeispiel der Figuren 7A bis 7D wird in einem ersten Schritt ein Chipträger 16 bereitgestellt, auf den eine Metallisierung, die bevorzugt ultraschallreibschweißfähig und/oder thermokompressionsfähig ist, innerhalb eines Kontaktbereiches 17 aufgebracht (Figur 7A).
In einem zweiten Schritt wird ein Halbleiterkörper 14, wie er beispielsweise mit einem der oben beschriebenen Verfahren hergestellt werden kann, mit einem Fügeverfahren, wie Ultraschweißen und/oder Thermokompression über seine rückseitigen Kontaktstrukturen 9, die bevorzugt einen ultraschallreibschweißfähigen und/oder thermokompressionsfähigen Oberflächenfügebereich 13 aufweisen, elektrisch leitend mit dem Kontaktbereich 17 des Chipträgers 16 verbunden (Figur 7B). Mit Hilfe eines Bondrahts 18 wird der Halbleiterkörper 14 vorderseitig mit einem Bondpad 19 auf dem Chipträger 16 elektrisch kontaktiert (Figur 7C).
In einem weiteren Schritt wird, wie in Figur 7D beispielhaft gezeigt, ein Füllmaterial 20 zwischen den Chipträger 16 und die Vorsprünge, die die Kontaktstrukturen 9 ausbilden, eingebracht. Als Füllmaterial 20 kann beispielsweise eines der folgenden Materialien verwendet werden: Epoxidharze, die beispielsweise warmhärtend sind, Silikone, Hybridmaterialien, die beispielsweise Epoxidharze und Silikone umfassen. Das Füllmaterial 20 weist gemäß einer Ausführungsform einen Füllstoff, wie beispielsweise Titanoxid auf.

Die Erfindung ist nicht durch die Beschreibung anhand der Ausführungsbeispiele auf diese beschränkt. Vielmehr umfasst die Erfindung jede Kombination von Merkmalen in den Patentansprüchen.

## Patentansprüche

1. Strahlungsemittierender Halbleiterkörper (14) mit:
- einer epitaktischen Halbleiterschichtenfolge (3) mit einer aktiven Zone (4), die dazu geeignet ist, elektromagnetische Strahlung zu erzeugen,
- einer Trägerschicht (1), die dazu vorgesehen ist, die epitaktische Halbleiterschichtenfolge (3) mechanisch zu stabilisieren, wobei die Trägerschicht ein metallisches Material aufweist, und
- Kontaktstrukturen (9, 91) zur elektrischen Kontaktierung des Halbleiterkörpers (14), die jeweils einen Volumenbereich (12) und einen Oberflächenfügebereich (13) aufweisen, wobei der Oberflächenfügebereich (13) aus einem Material gebildet ist, das von dem Material des Volumenbereichs (12) verschieden ist, wobei die Kontaktstrukturen an einer Rückseite des Halbleiterkörpers angeordnet sind, die einer strahlungsemittierenden Vorderseite gegenüber liegt,
dadurch charakterisiert, dass
die Kontaktstrukturen (9, 91) pilzförmige Vorsprünge bilden, wobei die Volumenbereiche (12) den Stiel der Pilze und die Oberflächenfügebereiche (13) die Kappe der Pilze ausbilden.

2. Strahlungsemittierender Halbleiterkörper (14) nach dem vorherigen Anspruch, bei dem der Volumenbereich (12) aus dem gleichen Material wie die Trägerschicht (1) gebildet ist.

3. Strahlungsemittierender Halbleiterkörper nach einem der obigen Ansprüche, bei dem die Trägerschicht (1) ein metallisches Material aufweist, das aus der folgenden Gruppe gewählt ist: Nickel, Molybdän, Kupfer.

4. Strahlungsemittierender Halbleiterkörper (14) nach einem der obigen Ansprüche, bei dem die Oberflächenfügebereiche (13) zumindest eines der folgenden Materialien aufweisen:
Gold, Kupfer, Aluminium.

5. Strahlungsemittierender Halbleiterkörper (14) nach einem der obigen Ansprüche, bei dem die Kontaktstrukturen (9) durch Vorsprünge gebildet sind, die jeweils eine Breite zwischen 20 µm und 200 µm und/oder eine Höhe zwischen 5 µm und 50 µm aufweisen, wobei die Grenzen eingeschlossen sind.

6. Strahlungsemittierender Halbleiterkörper (14) nach einem der obigen Ansprüche, bei dem die Oberflächenfügebereiche ultraschallreibschweißfähig und/oder thermokompressionsfähig ausgebildet ist.

7. Verfahren zur Herstellung eines strahlungsemittierenden Halbleiterkörpers (14) mit den Schritten:
- Bereitstellen einer epitaktischen Halbleiterschichtenfolge (3) mit einer aktiven Zone (4), die dazu geeignet ist, elektromagnetische Strahlung zu erzeugen,
- Aufbringen einer Trägerschicht (1) auf eine Hauptseite der epitaktischen Halbleiterschichtenfolge (3), wobei die Trägerschicht (1) zur mechanischen Stabilisierung der epitaktischen Halbleiterschichtenfolge (3) vorgesehen ist und ein metallisches Material aufweist,
- Aufbringen einer fügefähigen Schicht (11),
- Ausbilden von Kontaktstrukturen (9) mittels Fotolithographie auf der Trägerschicht (1), wobei die Kontaktstrukturen (9) jeweils einen Volumenbereich (12) und einen Oberflächenfügebereich (13) aufweisen und wobei die Kontaktstrukturen an einer Rückseite des Halbleiterkörpers angeordnet sind, die einer strahlungsemittierenden Vorderseite gegenüber liegt
dadurch charakterisiert, dass
die Kontaktstrukturen (9, 91) pilzförmige Vorsprünge bilden, wobei die Volumenbereiche (12) den Stiel der Pilze und die Oberflächenfügebereiche (13) die Kappe der Pilze ausbilden.

8. Verfahren nach dem vorherigen Anspruch, bei dem zwischen die Trägerschicht (1) und die fügefähige Schicht (11) eine weitere Schicht (10) aus dem gleichen Material wie die Trägerschicht (1) aufgebracht wird.

9. Verfahren nach dem vorherigen Anspruch, bei dem die Volumenbereiche (12) der Kontaktstrukturen (9) aus dem Material der weiteren Schicht (10) gebildet werden.

10. Verfahren nach Anspruch 7, bei dem die fügefähige Schicht (11) in direktem Kontakt auf die Trägerschicht (1) aufgebracht wird.

11. Verfahren nach einem der Ansprüche 7 bis 10, bei dem der Oberflächenfügebereich und/oder die fügefähige Schicht ultraschallreibschweißfähig und/oder thermokompressionsfähig ausgebildet ist.

12. Strahlungsemittierendes Halbleiterbauelement mit einem strahlungsemittierenden Halbleiterkörper (14) nach einem der Ansprüche 1 bis 6, der auf einen Chipträger (16) aufgebracht ist.

13. Strahlungsemittierendes Halbleiterbauelement nach dem vorherigen Anspruch, bei dem der Halbleiterkörper (14) mittels Ultraschallreibschweißen oder Thermokompression auf den Chipträger (16) aufgebracht ist.

## Claims

1. Radiation-emitting semiconductor body (14) comprising:
- an epitaxial semiconductor layer sequence (3) having an active zone (4) which is suitable for generating electromagnetic radiation,
- a carrier layer (1) which is intended to mechanically stabilize the epitaxial semiconductor layer sequence (3), wherein the carrier layer comprises a metallic material, and
- contact structures (9, 91) for electrical contacting of the semiconductor body (14), which respectively have a volume region (12) and a surface bonding region (13), wherein
the surface bonding region (13) being formed from a material which is different from the material of the volume region (12), wherein the contact structures are arranged at a back side of the semiconductor body, the back side being opposite to a radiation emitting front side of the semiconductor body, **characterized in that**
the contact structures (9, 91) form mushroom-shaped projections, wherein the volume regions (12) form the stems of the mushrooms and the surface bonding regions (13) form the caps of the mushrooms.

2. Radiation-emitting semiconductor body (14) according to the preceding claim, wherein the volume region (12) is formed from the same material as the carrier layer (1).

3. Radiation-emitting semiconductor body according to one of the preceding claims, wherein the carrier layer (1) comprises a metallic material, which is preferably selected from the following group: nickel, molybdenum, copper.

4. Radiation-emitting semiconductor body (14) according to one of the preceding claims, wherein the surface bonding regions (13) comprise at least one of the following materials: gold, copper, aluminium.

5. Radiation-emitting semiconductor body (14) according to one of the preceding claims, wherein the contact structures (9) are formed by projections, which respectively have a width of between 20 µm and 200 µm and/or a height of between 5 µm and 50 µm, the limits being included.

6. Radiation-emitting semiconductor body (14) according to one of the preceding claims, wherein the surface bonding regions are formed so as to be ultrasound-friction weldable and/or thermocompressible.

7. Method for producing a radiation-emitting semiconductor body (14), comprising the steps:
- providing an epitaxial semiconductor layer sequence (3) having an active zone (4) which is suitable for generating electromagnetic radiation,
- applying a carrier layer (1) onto a main side of the epitaxial semiconductor layer sequence (3), the carrier layer (1) being intended to mechanically stabilize the epitaxial semiconductor layer sequence (3) and comprising a metallic material,
- applying a bondable layer (11),
- forming contact structures (9) by means of photolithography on the carrier layer (1), the contact structures (9) respectively having a volume region (12) and a surface bonding region (13) and wherein the contact structures are arranged at a back side of the semiconductor body, the back side being opposite to a radiation emitting front side of the semiconductor body,
**characterized in that**
the contact structures (9, 91) form mushroom-shaped projections, wherein the volume regions (12) form the stems of the mushrooms and the surface bonding regions (13) form the caps of the mushrooms.

8. Method according to the preceding claim, wherein a further layer (10) of the same material as the carrier layer (1) is applied between the carrier layer (1) and the bondable layer (11).

9. Method according to the preceding claim, wherein the volume regions (12) of the contact structures (9) are formed from the material of the further layer (10).

10. Method according to claim 7, wherein the bondable layer (11) is applied in direct contact onto the carrier layer (1).

11. Method according to one of claims 7 to 10, wherein the surface bonding region and/or the bondable layer is formed so as to be ultrasound-friction weldable and/or thermocompressible.

12. Radiation-emitting semiconductor component having a radiation-emitting semiconductor body (14) according to one of claims 1 to 6, which is applied onto a chip carrier (16).

13. Radiation-emitting semiconductor component according to the preceding claim, wherein the semiconductor body (14) is applied onto the chip carrier (16) by means of ultrasound-friction welding or thermocompression.

## Revendications

1. Corps semi-conducteur (14) émetteur de rayonnement, comprenant :
- une succession épitaxiale de couches semi-conductrices (3) dotée d'une zone active (4) qui est apte à générer un rayonnement électromagnétique,
- une couche de support (1) qui est prévue pour mécaniquement stabiliser la succession épitaxiale de couches semi-conductrices (3), la couche de support présentant une matière métallique, et
- des structures de contact (9, 91) pour la mise en contact électrique du corps semi-conducteur (14), lesquelles présentent respectivement une zone volumique (12) et une zone de jonction de surface (13), la zone de jonction de surface (13) étant formée dans une matière qui est différente de la matière de la zone volumique (12), les structures de contact étant disposées sur un côté arrière du corps semi-conducteur, lequel côté arrière est opposé à un côté avant émetteur de rayonnement,
**caractérisé en ce que**
les structures de contact (9, 91) forment des saillies en forme de champignon, les zones volumiques (12) formant la tige des champignons et les zones de jonction de surface (13) formant le capuchon des champignons.

2. Corps semi-conducteur (14) émetteur de rayonnement selon la revendication précédente, dans lequel la zone volumique (12) est conçue de la même matière que la couche de support (1).

3. Corps semi-conducteur (14) émetteur de rayonnement selon l'une quelconque des revendications précédentes, dans lequel la couche de support (1) présente une matière métallique qui est sélectionnée dans le groupe suivant :
nickel, molybdène, cuivre.

4. Corps semi-conducteur (14) émetteur de rayonnement selon l'une quelconque des revendications précédentes, dans lequel les zones de jonction de surface (13) présentent au moins une des matières suivantes : or, cuivre, aluminium.

5. Corps semi-conducteur (14) émetteur de rayonnement selon l'une quelconque des revendications précédentes, dans lequel les structures de contact (9) sont formées par des saillies qui présentent respectivement une largeur comprise entre 20 µm et 50 µm et/ou une hauteur comprise entre 5 µm et 50 µm, les limites étant inclues.

6. Corps semi-conducteur (14) émetteur de rayonnement selon l'une quelconque des revendications précédentes, dans lequel les zones de jonction de surface sont conçues de manière apte au soudage aux ultrasons par friction et/ou de manière apte à la thermocompression.

7. Procédé de fabrication d'un corps semi-conducteur (14) émetteur de rayonnement, comprenant les étampes :
- fourniture d'une succession épitaxiale de couches semi-conductrices (3) dotée d'une zone active (4) qui est apte à générer un rayonnement électromagnétique,
- application d'une couche de support (1) sur une côté principale de la succession épitaxiale de couches semi-conductrices (3), la couche de support (1) étant prévue pour la stabilisation mécanique de la succession épitaxiale de couches semi-conductrices (3) et présentant une matière métallique,
- application d'une couche (11) apte à la jonction,
- formation des structures de contact (9) sur la couche de support (1) par photolithographie, les structures de contact (9) présentant respectivement une zone volumique (12) et une zone de jonction de surface (13), et les structures de contact étant disposées sur un côté arrière du corps semi-conducteur, lequel côté arrière est opposé à un côté avant émetteur de rayonnement,
**caractérisé en ce que**
les structures de contact (9, 91) forment des saillies en forme de champignon, les zones volumiques (12) formant la tige des champignons et les zones de jonction de surface (13) formant le capuchon des champignons.

8. Procédé selon la revendication précédente, dans lequel une couche supplémentaire (10) constituée de la même matière que la couche de support (1) est appliquée entre la couche de support (1) et la couche (11) apte à la jonction.

9. Procédé selon la revendication précédente, dans lequel les zones volumiques (12) des structures de contact (9) sont formées à partir de la matière de la couche supplémentaire (10).

10. Procédé selon la revendication 7, dans lequel la couche (11) apte à la jonction est appliquée en contact direct sur la couche de support (1).

11. Procédé selon l'une quelconque des revendications 7 à 10, dans lequel la zone de jonction de surface et/ou la couche apte à la jonction sont réalisées de manière apte au soudage aux ultrasons par friction et/ou de manière apte à la thermocompression.

12. Composant semi-conducteur émetteur de rayonnement doté d'un corps semi-conducteur émetteur de rayonnement (14) selon l'une quelconque des revendications 1 à 6, lequel est placé sur un support de puce (16).

13. Composant semi-conducteur émetteur de rayonnement selon la revendication précédente, dans lequel le corps semi-conducteur (14) est appliqué sur le support de puce (16) par soudage aux ultrasons par friction ou par thermocompression.
